# EUROPEAN PATENT APPLICATION

(11) **EP 4 425 534 A1**
(43) Date of publication of application: **04.09.2024**
(21) Application number: 21962466.5
(22) Date of filing: 29.10.2021
(51) Int. Cl.: H01L 21/285, H01L 21/768, C23C 16/02, C23C 16/16, C23C 16/455

(54) **METHOD FOR PRODUCING SEMICONDUCTOR DEVICE, SUBSTRATE PROCESSING METHOD, SUBSTRATE PROCESSING APPARATUS, AND RECORDING MEDIUM**

(71) Applicant: Kokusai Electric Corporation, Tokyo 101-0045 (JP)
(72) Inventor: SANO, Atsushi, Toyama-shi, Toyama 939-2393 (JP); ZHANG, Fan, Toyama-shi, Toyama 939-2393 (JP); KADOSHIMA, Masaru, Toyama-shi, Toyama 939-2393 (JP)
(74) Representative: Bardehle Pagenberg Partnerschaft mbB Patentanwälte Rechtsanwälte
(86) International application number: PCT/JP2021/040027
(87) International publication number: WO 2023/073924

(57) **Abstract**

The present invention is capable of improving the characteristics of a metal-containing film that is formed on a base film, while suppressing oxidation of the base film. The present invention comprises: (a) a step in which a metal-containing gas that contains a metal element is supplied to a substrate on which a metal-containing film has been formed; (b) a step in which a reducing gas is supplied to the substrate; (c) a step in which a reducing gas and an oxygen-containing gas that contains oxygen atoms are supplied to the substrate; (d) a step in which a cycle comprising the steps (a) and (b) is repeated a first number of times; and (e) a step in which a cycle comprising the steps (a) and (c) is repeated a second number of times after the step (d).

## Description

### TECHNICAL FIELD

The present disclosure relates to a method of manufacturing a semiconductor device, a method of processing a substrate, a substrate processing apparatus, and a recording medium.

### BACKGROUND

A film formation process is performed as a process of manufacturing a semiconductor device to form a film on a substrate accommodated in a process chamber systems (for example, see Patent Document 1).

### Prior Art Documents

### Patent Documents

Patent Document 1: International Publication No.: 2006/134930

### SUMMARY

However, when forming a metal-containing film containing a metal element on a base film, the base film may be oxidized and impurities may be contained in the metal-containing film.

Embodiments of the present disclosure provide a technique capable of improving properties of a metal-containing film formed on a base film while suppressing oxidation of the base film.

According to embodiments of the present disclosure, there is provided a technique including: (a) supplying a metal-containing gas containing a metal element to a substrate on which a metal-containing film is formed; (b) supplying a reducing gas to the substrate; (c) supplying an oxygen-containing gas containing an oxygen atom and the reducing gas to the substrate; (d) repeating a cycle including (a) and (b) a first number of times; and (e) after (d), repeating a cycle including (a) and (c) a second number of times.

According to the present disclosure, it is possible to improve properties of a metal-containing film formed on a base film while suppressing oxidation of the base film.

### BRIEF DESCRIPTION OF DRAWINGS

FIG. 1 is a vertical cross-sectional view schematically illustrating a vertical process furnace of a substrate processing apparatus according to embodiments of the present disclosure.
FIG. 2 is a schematic horizontal cross-sectional view taken along line A-A in FIG. 1.
FIG. 3 is a schematic configuration diagram of a controller of the substrate processing apparatus according to embodiments of the present disclosure, and is illustrating a control system of the controller in a block diagram.
FIG. 4 is a diagram illustrating a substrate processing process according to embodiments of the present disclosure.

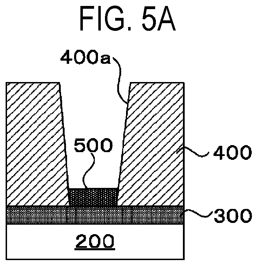

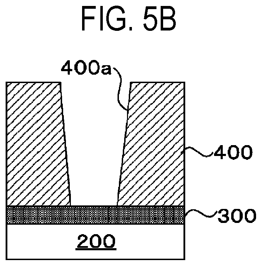

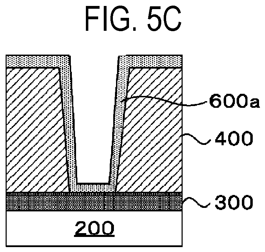

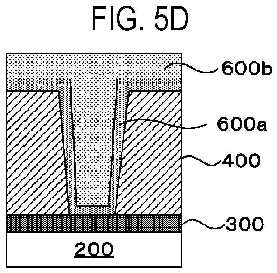

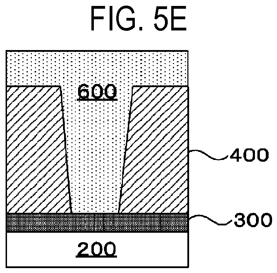

FIG. 5A is a diagram illustrating a cross-section of a substrate at a state in which a metal-containing film is yet to be formed in a recess on the substrate, FIG. 5B is a diagram illustrating the cross-section of the substrate at a state in which an oxide film formed in the recess on the substrate is etched, FIG. 5C is a diagram illustrating the cross-section of the substrate at a state in which a first metal-containing film is formed in the recess on the substrate, FIG. 5D is a diagram illustrating the cross-section of the substrate at a state in which a second metal-containing film is formed in the recess on the substrate, and FIG. 5E is a diagram illustrating the cross-section of the substrate at a state in which a metal-containing film is formed in the recess on the substrate.
FIG. 6 is a diagram illustrating a modification of the substrate processing process according to embodiments of the present disclosure.
FIG. 7 is a diagram illustrating a modification of the substrate processing process according to embodiments of the present disclosure.
FIG. 8 is a diagram illustrating a modification of the substrate processing process according to embodiments of the present disclosure.
FIG. 9 is a diagram illustrating a modification of the substrate processing process according to embodiments of the present disclosure.
FIG. 10 is a diagram illustrating a modification of the substrate processing process according to embodiments of the present disclosure.
FIG. 11 is a diagram illustrating a modification of the substrate processing process according to embodiments of the present disclosure.
FIG. 12 is a diagram illustrating a modification of the substrate processing process according to embodiments of the present disclosure.
FIG. 13 is a diagram illustrating a modification of the substrate processing process according to embodiments of the present disclosure.

### DETAILED DESCRIPTION

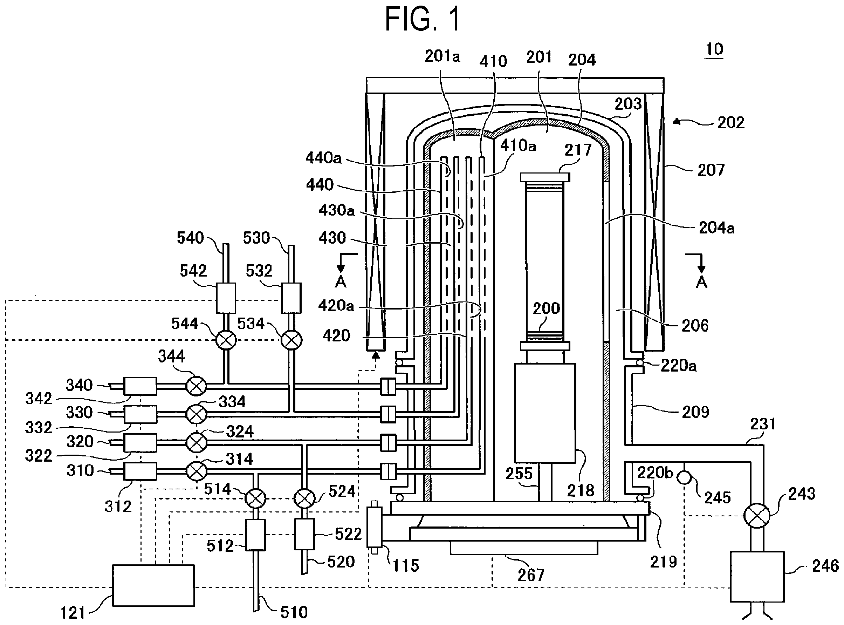

Hereinafter, the present disclosure will be described with reference to FIGS. 1 to 4 and FIGS. 5A to 5E. The drawings used in the following description are schematic. The dimensional relationships of respective elements, the ratios of respective elements, and the like illustrated in the drawings may not always correspond to the actual ones. Further, even among the drawings, the dimensional relationships of respective elements, the ratios of respective elements, and the like do not always match.

### (1) Configuration of Substrate Processing Apparatus

The substrate processing apparatus 10 includes a process furnace 202 provided with a heater 207 as a heating means (heating mechanism or heating system). The heater 207 is formed in a cylindrical shape, and is vertically installed by being supported on a heater base (not shown), which serves as a holding plate.

Inside the heater 207, an outer tube 203 which constitutes a reaction container (process container) is disposed concentrically with the heater 207. The outer tube 203 is made of a heat-resistant material such as quartz (SiO₂), silicon carbide (SiC) or the like. The outer tube 203 is formed in a cylindrical shape with an upper end closed and a lower end opened. Below the outer tube 203, a manifold (inlet flange) 209 is disposed concentrically with the outer tube 203. The manifold 209 is made of, for example, a metal such as stainless steel (SUS) or the like. The manifold 209 is formed in a cylindrical shape with upper and lower ends opened. An O-ring 220a as a seal member is installed between the upper end of the manifold 209 and the outer tube 203. As the manifold 209 is supported by the heater base, the outer tube 203 comes into a vertically installed state.

Inside the outer tube 203, an inner tube 204 that constitutes a reaction container is disposed. The inner tube 204 is made of, for example, a heat-resistant material such as quartz (SiO₂), silicon carbide (SiC) or the like. The inner tube 204 is formed in a cylindrical shape with an upper end closed and a lower end opened. A process container (reaction container) mainly includes the outer tube 203, the inner tube 204 and the manifold 209. A process chamber 201 is formed in a hollow portion of the process container (inside the inner tube 204).

The process chamber 201 is configured to be capable of accommodating wafers 200 as substrates in a state in which the wafers 200 are arranged in multiple stages in a vertical direction in a horizontal posture by a boat 217 to be described later.

In the process chamber 201, nozzles 410, 420, 430 and 440 are provided to penetrate the inner tube 204 and a side wall of the manifold 209. Gas supply pipes 310, 320, 330 and 340 are connected to the nozzles 410, 420, 430 and 440, respectively. However, the process furnace 202 of the present embodiments is not limited to the above-described form.

Mass flow controllers (MFCs) 312, 322, 332 and 342, which serve as flow rate controllers (flow rate control parts), and valves 314, 324, 334 and 344, which serve as opening/closing valves, are respectively installed on the gas supply pipes 310, 320, 330 and 340 sequentially from an upstream side. Gas supply pipes 510, 520, 530 and 540, which supply an inert gas, are respectively connected to the gas supply pipes 310, 320, 330 and 340 on a downstream side of the valves 314, 324, 334 and 344. MFCs 512, 522, 532 and 542, which serve as flow rate controllers (flow rate control parts), and valves 514, 524, 534 and 544, which serve as opening/closing valves, are respectively installed on the gas supply pipes 510, 520, 530 and 540 sequentially from an upstream side.

Nozzles 410, 420, 430 and 440 are respectively connected to one ends of the gas supply pipes 310, 320, 330 and 340. The nozzles 410, 420, 430 and 440 are configured as L-shaped nozzles. Horizontal portions of the nozzles 410, 420, 430 and 440 are installed to penetrate the side wall of the manifold 209 and the inner tube 204. Vertical portions of the nozzles 410, 420, 430 and 440 are installed inside a channel-shaped (groove-shaped) spare chamber 201a that protrudes radially outward of the inner tube 204 and extends in the vertical direction. In the spare chamber 201a, the vertical portions of the nozzles 410, 420, 430 and 440 are installed to extend upward (upward in an arrangement direction of the wafers 200) along an inner wall of the inner tube 204.

The nozzles 410, 420, 430 and 440 are installed to extend from a lower region of the process chamber 201 to an upper region of the process chamber 201. The nozzles 410, 420, 430 and 440 respectively have a plurality of gas supply holes 410a, 420a, 430a and 440a, which are formed at positions facing the wafers 200. Thus, processing gases are supplied to the wafers 200 respectively from the gas supply holes 410a, 420a, 430a and 440a of the nozzles 410, 420, 430 and 440. The gas supply holes 410a, 420a, 430a and 440a are provided at a plurality of positions from a lower portion to an upper portion of the inner tube 204. Each of the gas supply holes 410a, 420a, 430a and 440a has a same opening area, and is provided at a same opening pitch. However, the gas supply holes 410a, 420a, 430a and 440a are not limited to the above-described form. For example, the opening area may be gradually increased from the lower portion to the upper portion of the inner tube 204. By doing so, flow rates of gases supplied from the gas supply holes 410a, 420a, 430a and 440a may be made more uniform.

The gas supply holes 410a, 420a, 430a and 440a of the nozzles 410, 420, 430 and 440 are provided in plurality at height positions from a lower portion to an upper portion of the boat 217, which will be described later. Therefore, the processing gases supplied into the process chamber 201 from the gas supply holes 410a, 420a, 430a and 440a of the nozzles 410, 420, 430 and 440 are supplied to an entire arrangement region of the wafers 200 accommodated from the lower portion to the upper portion of the boat 217. The nozzles 410, 420, 430 and 440 may be installed to extend from the lower region to the upper region of the process chamber 201, but are preferably installed so as to extend to the vicinity of a ceiling of the boat 217.

As a processing gas, a metal-containing gas, which is a precursor gas containing a metal element, is supplied from the gas supply pipe 310 into the process chamber 201 through the MFC 312, the valve 314 and the nozzle 410.

As a processing gas, a reducing gas is supplied from the gas supply pipe 320 into the process chamber 201 through the MFC 322, the valve 324, and the nozzle 420.

As a processing gas, an oxygen-containing gas containing oxygen atoms (O) is supplied from the gas supply pipe 330 into the process chamber 201 through the MFC 332, the valve 334, and the nozzle 430.

As a processing gas, a halogen-containing gas containing a halogen element is supplied from the gas supply pipe 340 into the process chamber 201 through the MFC 342, the valve 344, and the nozzle 440.

An inert gas is supplied from gas supply pipes 510, 520, 530 and 540 into the process chamber 201 through the MFCs 512, 522, 532 and 542, the valves 514, 524, 534 and 544, and the nozzles 410, 420, 430 and 440, respectively.

As the inert gas, for example, a nitrogen (N₂) gas and a rare gas such as an argon (Ar) gas, a helium (He) gas, a neon (Ne) gas, a xenon (Xe) gas or the like may be used. One or more of these gases may be used as the inert gas. The same also applies to other inert gases described below.

A processing gas supply system mainly includes the gas supply pipes 310, 320, 330 and 340, the MFCs 312, 322, 332 and 342, the valves 314, 324, 334 and 344, and the nozzles 410, 420, 430 and 440, but the nozzles 410, 420, 430 and 440 may solely be considered as a processing gas supply system. The processing gas supply system may also be simply referred to as a gas supply system. When a metal-containing gas flows from the gas supply pipe 310, a metal-containing gas supply system mainly includes the gas supply pipe 310, the MFC 312, and the valve 314, but the nozzle 410 may also be included in the metal-containing gas supply system. In addition, when a reducing gas is flows from the gas supply pipe 320, a reducing gas supply system mainly includes the gas supply pipe 320, the MFC 322, and the valve 324, but the nozzle 420 may also be included in the reducing gas supply system. Further, when an oxygen-containing gas flows from the gas supply pipe 330, an oxygen-containing gas supply system mainly includes the gas supply pipe 330, the MFC 332, and the valve 334, but the nozzle 430 may also be included in the oxygen-containing gas supply system. Furthermore, when a halogen-containing gas flows from the gas supply pipe 340, a halogen-containing gas supply system mainly includes the gas supply pipe 340, the MFC 342, and the valve 344, but the nozzle 440 may also be included in the halogen-containing gas supply system. Moreover, an inert gas supply system mainly includes the gas supply pipes 510, 520, 530 and 540, the MFCs 512, 522, 532 and 542, and the valves 514, 524, 534 and 544. The inert gas supply system may also be referred to as a rare gas supply system.

In a gas supply method according to the present embodiments, a gas is conveyed via the nozzles 410, 420, 430 and 440 disposed in the spare chamber 201a in an annular vertical space defined by the inner wall of the inner tube 204 and end portions of a plurality of wafers 200. Then, the gas is injected into the inner tube 204 from the plurality of gas supply holes 410a, 420a, 430a and 440a of the nozzles 410, 420, 430 and 440 formed at positions facing the wafers. More specifically, the processing gases and the like are injected in a direction parallel to surfaces of the wafers 200 by the gas supply holes 410a of the nozzle 410, the gas supply holes 420a of the nozzle 420, the gas supply holes 430a of the nozzle 430, and the gas supply holes 440a of the nozzle 440.

An exhaust hole (exhaust port) 204a is a through-hole formed at a side wall of the inner tube 204 at a position facing the nozzles 410, 420, 430 and 440, and is, for example, a slit-shaped through-hole elongated in the vertical direction. The gas supplied into the process chamber 201 from the gas supply holes 410a, 420a, 430a and 440a of the nozzles 410, 420, 430 and 440 and flowing over the surfaces of the wafers 200 flows through the exhaust hole 204a into an exhaust path 206, which is a gap formed between the inner tube 204 and the outer tube 203. Then, the gas flowing into the exhaust path 206 flows into an exhaust pipe 231 and is discharged to an outside of the process furnace 202.

The exhaust hole 204a is formed at a position facing the plurality of wafers 200. The gas supplied from the gas supply holes 410a, 420a, 430a and 440a to the vicinity of the wafers 200 in the process chamber 201 flows in a horizontal direction, and then flows into the exhaust path 206 through the exhaust hole 204a. The exhaust hole 204a is not limited to being configured as a slit-shaped through-hole, and may be configured as a plurality of holes.

The manifold 209 is provided with the exhaust pipe 231 that exhausts an atmosphere in the process chamber 201. A pressure sensor 245, which serves as a pressure detector (pressure detection part) for detecting a pressure inside the process chamber 201, an APC (Automatic Pressure Controller) valve 243 and a vacuum pump 246, which serves as a vacuum-exhauster, are connected to the exhaust pipe 231 sequentially from an upstream side. By opening and closing the APC valve 243 while operating the vacuum pump 246, it is possible to perform vacuum-exhaust of an inside of the process chamber 201 and to stop the vacuum-exhaust of the inside of the process chamber 201. Furthermore, by adjusting a valve-opening state of the APC valve 243 while operating the vacuum pump 246, it is possible to regulate the pressure inside the process chamber 201. An exhaust system mainly includes the exhaust hole 204a, the exhaust path 206, the exhaust pipe 231, the APC valve 243 and the pressure sensor 245. The vacuum pump 246 may also be considered to be included in the exhaust system.

Below the manifold 209, a seal cap 219 as a furnace opening lid capable of hermetically closing an opening at a lower end of the manifold 209 is installed. The seal cap 219 is configured to contact the lower end of the manifold 209 from below in the vertical direction. The seal cap 219 is made of, for example, a metal such as SUS or the like, and is formed in a disc shape. On an upper surface of the seal cap 219, an O-ring 220b as a seal member that contacts the lower end of the manifold 209 is installed. On an opposite side of the seal cap 219 from the process chamber 201, a rotator 267 for rotating a boat 217 that accommodates the wafers 200 is installed. A rotation shaft 255 of the rotator 267 passes through the seal cap 219 and is connected to the boat 217. The rotator 267 is configured to rotate the boat 217 to rotate the wafers 200. The seal cap 219 is configured to be moved up and down in the vertical direction by a boat elevator 115, which is an elevator installed vertically outside the outer tube 203. The boat elevator 115 is configured to be capable of loading and unloading the boat 217 into and from the process chamber 201 by moving the seal cap 219 up and down. The boat elevator 115 is configured as a transporter (transport system) that transfers the boat 217 and the wafers 200 accommodated on the boat 217 into and out of the process chamber 201.

The boat 217, which serves as a substrate support, is configured to arrange a plurality of, for example, 25 to 200, wafers 200 in a horizontal posture and at intervals in the vertical direction with centers thereof aligned with one other. The boat 217 is made of, for example, a heat-resistant material such as quartz or SiC. The lower portion of the boat 217 is supported on a heat insulating cylinder 218 made of, for example, a heat-resistant material such as quartz or SiC and configured as a cylindrical member. This configuration makes it difficult for heat from the heater 207 to be transferred toward the seal cap 219. However, the present embodiments are not limited to the above-described form. For example, instead of installing the heat insulating cylinder 218, heat insulating plates made of a heat-resistant material such as quartz or SiC may be supported horizontally in multiple stages (not shown) at the lower portion of the boat 217.

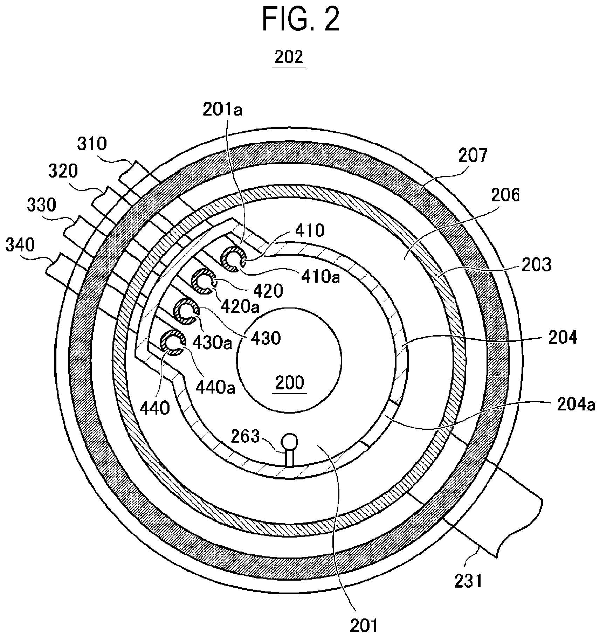

As shown in FIG. 2, a temperature sensor 263 as a temperature detector is installed in the inner tube 204. By regulating a supply amount of electricity to the heater 207 based on temperature information detected by the temperature sensor 263, a temperature inside the process chamber 201 becomes a desired temperature distribution. The temperature sensor 263 is formed in an L shape just like the nozzles 410, 420, 430 and 440, and is installed along the inner wall of the inner tube 204.

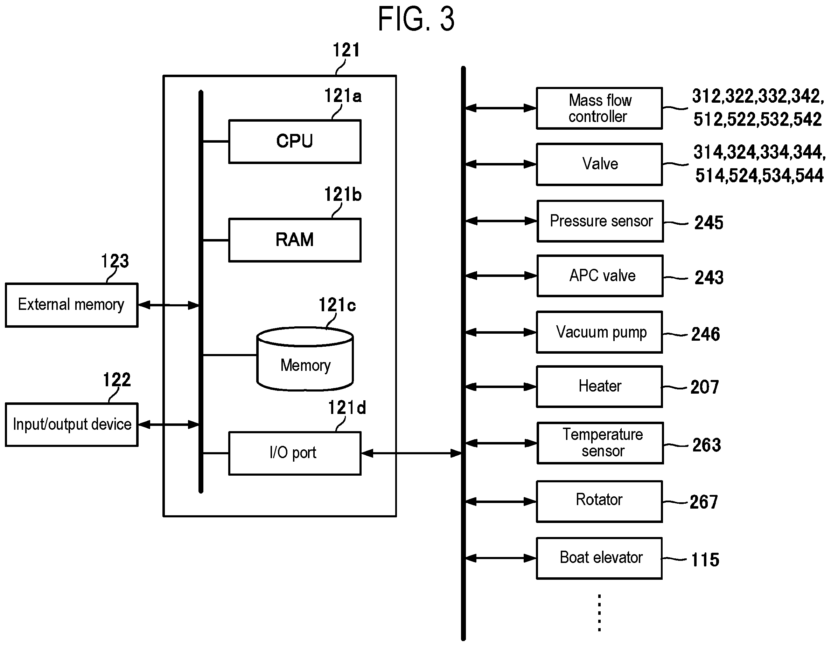

As shown in FIG. 3, a controller 121 as a control part (control means) is configured as a computer including a CPU (Central Processing Unit) 121a, a RAM (Random Access Memory) 121b, a memory 121c and an I/O port 121d. The RAM 121b, the memory 121c and the I/O port 121d are configured to be capable of exchanging data with the CPU 121a via an internal bus. An input/output device 122 including, for example, a touch panel or the like is connected to the controller 121.

The memory 121c includes, for example, a flash memory, an HDD (Hard Disk Drive) or the like. The memory 121c stores, in a readable manner, a control program for controlling operations of the substrate processing apparatus, a process recipe in which procedures and conditions of a below-described method of manufacturing a semiconductor device (substrate processing method) are written, and the like. The process recipe is a combination that enables the controller 121 to execute each process (each step) in a below-described method of manufacturing a semiconductor (substrate processing method) to obtain a predetermined result. The process recipe functions as a program. Hereinafter, the process recipe, the control program and the like are collectively and simply referred to as a program. As used herein, the term "program" may refer to a case of including a group of the process recipe, a case of including a group of the control program, or a case of including a combination of the process recipe and the control program. The RAM 121b is configured as a memory area (work area) in which programs, data, and the like read by the CPU 121a are temporarily held.

The I/O port 121d is connected to the MFCs 312, 322, 332, 342, 512, 522, 532 and 542, the valves 314, 324, 334, 344, 514, 524, 534 and 544, the pressure sensor 245, the APC valve 243, the vacuum pump 246, the heater 207, the temperature sensor 263, the rotator 267, the boat elevator 115 and the like.

The CPU 121a is configured to read the control program from the memory 121c and execute the control program thus read. The CPU 121a is also configured to read the recipe from the memory 121c in response to an operation command inputted from the input/output device 122 or the like. The CPU 121a is configured to be capable of controlling, according to the contents of the recipe thus read, the flow rate regulating operations for various gases by the MFCs 312, 322, 332, 342, 512, 522, 532 and 542, the opening/closing operations of the valves 314, 324, 334, 344, 514, 524, 534 and 544, the opening/closing operation of the APC valve 243, the pressure regulating operation by the APC valve 243 based on the pressure sensor 245, the temperature regulating operation of the heater 207 based on the temperature sensor 263, the start and stop of the vacuum pump 246, the rotation and rotation speed adjustment operation of the boat 217 by the rotator 267, the raising and lowering operation of the boat 217 by the boat elevator 115, the operation of accommodating the wafers 200 on the boat 217, and the like.

The controller 121 may be configured by installing, on a computer, the aforementioned program stored on an external memory (e.g., a magnetic tape, a magnetic disk such as a flexible disk or a hard disk, an optical disk such as a CD or a DVD, a magneto-optical disk such as an MO, or a semiconductor memory such as a USB memory or a memory card) 123. The memory 121c and the external memory 123 are configured as computer-readable recording media. Hereinafter, the memory 121c and the external memory 123 are collectively and simply referred to as a recording medium. As used herein, the term "recording medium" may refer to a case of including a group of the memory 121c, a case of including a group of the external memory 123, or a case of including both the memory 121c and the external memory 123. The provision of the program to the computer may be performed using a communication means such as the Internet or a dedicated line without using the external memory 123.

### (2) Substrate Processing Process (Substrate Processing Method)

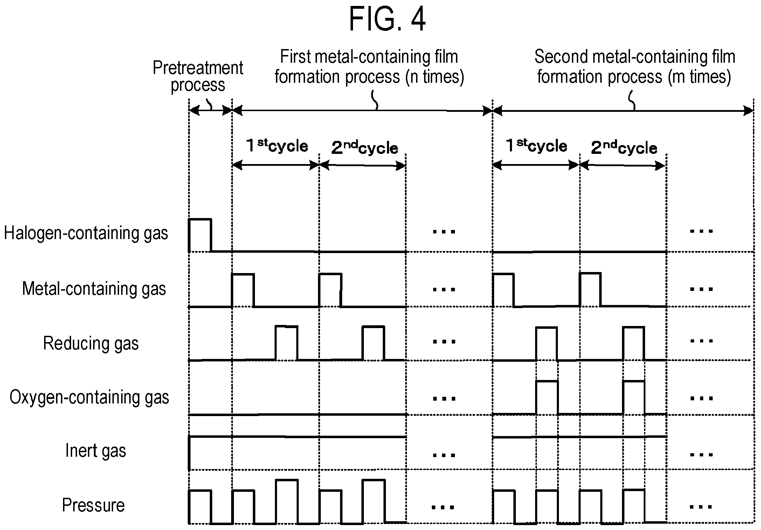

As one of processes of manufacturing a semiconductor device, an example of a process of forming a metal-containing film 600 containing a metal element on a wafer 200 on which a metal-containing film 300 containing a metal element as a base film is formed will be described with reference to FIG. 4. The process of forming the metal-containing film 600 on the wafer 200 on which the metal-containing film 300 is formed is performed using the process furnace 202 of the substrate processing apparatus 10 described above. In the following description, the operation of each part constituting the substrate processing apparatus 10 is controlled by the controller 121.

The substrate processing process (the process of manufacturing a semiconductor device) according to the present embodiments includes:
(a) supplying a metal-containing gas containing a metal element to a wafer 200 on which a metal-containing film is formed;
(b) supplying a reducing gas to the wafer 200;
(c) supplying an oxygen-containing gas containing an oxygen atom and the reducing gas to the wafer 200;
(d) repeating a cycle including (a) and (b) a first number of times; and
(e) after (d), repeating a cycle including (a) and (c) a second number of times.

When the term "wafer" is used herein, it may refer to "a wafer itself" or "a stacked body of a wafer and a predetermined layer or film formed on the surface of the wafer." When the term "wafer surface" is used herein, it may refer to "a surface of a wafer itself" or "a surface of a predetermined layer, a film or the like formed on a wafer." In addition, when the term "substrate" is used herein, it may be synonymous with the term "wafer."

### (Wafer Loading)

After a plurality of wafers 200 are charged to the boat 217 (wafer charging), the boat 217 supporting the plurality of wafers 200 is lifted by the boat elevator 115, loaded into the process chamber 201, and accommodated inside the process container (boat loading), as shown in FIG. 1. In this state, the seal cap 219 closes a lower end opening of the outer tube 203 via the O-ring 220.

### (Pressure Regulation and Temperature Regulation)

The inside of the process chamber 201, i.e., a space in which the wafers 200 exist, is vacuum-exhausted by the vacuum pump 246 so as to have a desired pressure (degree of vacuum). At this time, the pressure inside the process chamber 201 is measured by the pressure sensor 245, and the APC valve 243 is feedback-controlled based on pressure information measured (pressure regulation). The vacuum pump 246 keeps operating at least until the processing on the wafers 200 is completed.

Furthermore, the inside of the process chamber 201 is heated by the heater 207 so as to reach a desired temperature. At this time, the supply amount of electricity to the heater 207 is feedback-controlled based on the temperature information detected by the temperature sensor 263 so that the inside of the process chamber 201 becomes a desired temperature distribution (temperature regulation). The heating of the inside of the process chamber 201 by the heater 207 is continuously performed at least until the processing on the wafers 200 is completed.

As the metal-containing film 300 serving as the base film, a film containing, for example, at least one selected from the group of tungsten (W), molybdenum (Mo), copper (Cu) and cobalt (Co), which are metal elements and transition metals (transition elements), may be used. The metal-containing film 300 may be used as a metal wiring. The metal-containing film 300 may be a metal wiring M1 at a lowest layer of a wiring layer or a metal wiring My at an intermediate layer of the wiring layer (where y is a natural number).

For example, as shown in FIG. 5A, when a metal-containing film 600 containing a metal element is formed and embedded in a recess 400a on a wafer 200with a metal-containing film 300 formed thereon, while an insulating film 400 is formed on the metal-containing film 300 and the recess 400a such as a trench or a hole is formed in the insulating film 400, a metal oxide film 500, which is a natural oxide film, may be formed on a surface of the metal-containing film 300 in the recess 400a. In particular, the metal oxide film 500 may be formed on the surface since transition metals such as W, Mo, Cu, and Co are easily oxidized. If the metal oxide film 500 is formed and remains without being removed, a contact resistance between the metal-containing film 300 and the metal-containing film 600 embedded in the recess 400a may possibly increase. When forming a ruthenium (Ru) film as an example of the metal-containing film 600, it is demanded to reduce the contact resistance in order to make use of the low resistance feature of the Ru film.

Therefore, in the substrate processing process (the process of manufacturing the semiconductor device) according to the present embodiments, before forming the metal-containing film 600 in the recess 400a, a pretreatment process is performed in which in the same process chamber 201, a halogen-containing gas containing a halogen element is supplied to the wafer 200 to remove at least a portion of the metal oxide film 500. That is, the pretreatment process and a film formation process are performed consecutively in the same process chamber (in-situ). That is, after the metal oxide film 500 is removed in the pretreatment process described later, the film formation process described later is performed in the same process chamber 201 to form the metal-containing film 600.

### A. Pretreatment Process

### (Halogen-Containing Gas Supply: Step S1)

The valve 344 is opened to flow a halogen-containing gas into the gas supply pipe 340. A flow rate of the halogen-containing gas is regulated by the MFC 342. The halogen-containing gas is supplied into the process chamber 201 from the gas supply holes 440a of the nozzle 440, and is exhausted from the exhaust pipe 231. At this time, the halogen-containing gas is supplied to the wafer 200. At this time, the valve 544 is simultaneously opened to flow an inert gas into the gas supply pipe 540. A flow rate of the inert gas flowing through the gas supply pipe 540 is regulated by the MFC 542. The inert gas is supplied into the process chamber 201 together with the halogen-containing gas, and is exhausted from the exhaust pipe 231. At this time, in order to prevent the halogen-containing gas from entering the nozzles 410, 420 and 430, the valves 514, 524 and 534 are opened to flow the inert gas into the gas supply pipes 510, 520 and 530. The inert gas is supplied into the process chamber 201 via the gas supply pipes 310, 320 and 330, and the nozzles 410, 420 and 430, and is exhausted from the exhaust pipe 231.

At this time, the APC valve 243 is controlled so that the pressure inside the process chamber 201 is regulated to a pressure within a range of, for example, 1 to 3990 Pa. The supply flow rate of the halogen-containing gas controlled by the MFC 342 is, for example, within a range of 0.05 to 20 slm. The supply flow rate of the inert gas controlled by the MFCs 512, 522, 532 and 542 is, for example, within a range of 0.1 to 50 slm. The notation of a numerical range such as "1 to 3990 Pa" in the present disclosure means that the lower limit value and the upper limit value are included in the range. Therefore, for example, "1 to 3990 Pa" means " 1 Pa or more and 3990 Pa or less." The same applies to other numerical ranges.

At this time, the gases flowing into the process chamber 201 are the halogen-containing gas and the inert gas. The halogen-containing gas undergoes a substitution reaction with at least a portion of the metal oxide film 500 formed on the metal-containing film 300. That is, O in the metal oxide film 500 reacts with the halogen element. O is then desorbed from the metal oxide film 500, and is discharged from the process chamber 201 as a reaction by-product. That is, at least a portion of the metal oxide film 500 is removed (etched).

As the halogen-containing gas, for example, a gas capable of selectively etching the metal oxide film 500 formed in the recess 400a on the wafer 200 is used. As the halogen-containing gas, a gas containing a halogen element, for example, one or more chlorine (Cl) atoms and one or more oxygen (O) atoms, may be used. That is, an oxyhalide having a molecular structure of MOₓCl_{y} may be used as the halogen-containing gas. Herein, M includes, for example, at least one selected from the group of phosphorus (P), sulfur (S), and carbon (C). As the oxyhalide, for example, phosphorus oxychloride (POCl₃), thionyl chloride (SOCl₂), carbonyl dichloride (COCl₂) gas, or the like may be used. One or more of these substances may be used as the halogen-containing gas.

When the oxyhalide is used as the halogen-containing gas as described above, O in the metal oxide film 500 reacts with Cl and O and is desorbed from the metal oxide film 500. Therefore, as shown in FIG. 5B, the metal oxide film 500 may be selectively etched. For example, the metal oxide film 500 may be selectively etched without etching the insulating film 400 formed of a silicon oxide (SiO₂) film. That is, the halogen-containing gas may also be referred to as an etching gas for etching the metal oxide film 500.

### (Removal of Residual Gas (Exhaust): Step S2)

After a predetermined time, for example, 1 to 600 seconds, is elapsed after starting the supply of the halogen-containing gas, the valve 344 of the gas supply pipe 340 is closed to stop the supply of the halogen-containing gas. That is, the time for supplying the halogen-containing gas to the wafer 200 is, for example, 1 to 600 seconds. At this time, the APC valve 243 of the exhaust pipe 231 is kept open, and the inside of the process chamber 201 is vacuum-exhausted by the vacuum pump 246 to remove an unreacted halogen-containing gas or a halogen-containing gas contributed to the etching of the metal oxide film 500, which remains in the process chamber 201, from the inside of the process chamber 201 (exhaust of the space where the wafers 200 exist). That is, the inside of the process chamber 201 is purged. At this time, the valves 514, 524, 534 and 544 are kept open to maintain the supply of the inert gas into the process chamber 201. The inert gas acts as a purge gas, and may enhance the effect of removing the unreacted halogen-containing gas or the halogen-containing gas contributed to the etching, which remains in the process chamber 201, from the inside of the process chamber 201.

The above-mentioned pretreatment process may also be referred to as a metal oxide film removal process, a pre-etching process, or a pre-cleaning process.

### B. Metal-Containing Film Formation Process (Film Formation Process)

### [First Metal-Containing Film Formation Process]

### (Metal-Containing Gas Supply: Step S11)

The valve 314 is opened, and a metal-containing gas, which is a precursor gas, flows into the gas supply pipe 310. A flow rate of the metal-containing gas is regulated by the MFC 312. The metal-containing gas is supplied into the process chamber 201 from the gas supply holes 410a of the nozzle 410, and is exhausted from the exhaust pipe 231. At this time, the valve 514 is simultaneously opened to flow an inert gas into the gas supply pipe 510. A flow rate of the inert gas flowing through the gas supply pipe 510 is regulated by the MFC 512. The inert gas is supplied into the process chamber 201 together with the metal-containing gas, and is exhausted from the exhaust pipe 231. At this time, in order to prevent the metal-containing gas from entering the nozzles 420, 430 and 440, the valves 524, 534 and 544 are opened to flow the inert gas into the gas supply pipes 520, 530 and 540. The inert gas is supplied into the process chamber 201 via the gas supply pipes 320, 330 and 340 and the nozzles 420, 430 and 440, and is exhausted from the exhaust pipe 231.

At this time, the APC valve 243 is controlled so that the pressure inside the process chamber 201 is regulated to a pressure within a range of, for example, 1 to 3990 Pa. The supply flow rate of the metal-containing gas controlled by the MFC 312 is, for example, in a range of 0.05 to 1 slm. The supply flow rate of the inert gas controlled by the MFCs 512, 522, 532 and 542 is, for example, within a range of 0.1 to 50 slm.

At this time, the gases flowing into the process chamber 201 are the metal-containing gas and the inert gas. That is, as shown in FIG. 5B, the metal-containing gas is supplied to the wafer 200 from which the metal oxide film 500 is removed, and a metal-containing layer is formed on the wafer 200 (the insulating film 400 on the surface and an inside of the recess 400a). The metal-containing layer may be a metal layer containing other elements, or may be an adsorption layer of the metal-containing gas.

As the metal-containing gas, a gas containing, for example, a transition metal (transition element) as a metal element may be used, and preferably a gas containing a platinum group element as a Group 8 element may be used. As the metal-containing gas, for example, a Ru-containing gas containing ruthenium (Ru) may be used. By using a gas containing a transition metal, which is a platinum group element and a group 8 element in this way, it is possible to form a metal-containing film with a low resistance. Further, as the metal-containing gas, a gas containing a metal element and a carbonyl group may be used. This makes it possible to improve a film formation rate.

As the metal-containing gas, it may be possible to use, for example, gases obtained by vaporizing organic metal materials such as bisethylcyclopentadienylruthenium (Ru(C₂H₅C₅H₄)₂), butylruthenocene (Ru(C₅H₅)(C₄H₉C₅H₄), tris-2,4-octanedionateruthenium (Ru[CH₃COCHCO(CH₂)₃CH₃]₃), 2,4 dimethylpentadienylethylcyclopentadienylruthenium (Ru(C₂H₅C₅H₄)((CH₃)C₅H₅)), Ru(C₇H₈)(C₇H₁₁O₂), dicarbonylbis(5-methyl-2,4-hexanediketonate)ruthenium(II) (C₁₆H₂₂O₆Ru), trirutheniumdodecacarbonyl (Ru₃(CO)₁₂), η4-2,3-dimethylbutadienerutheniumtricarbonyl ((DMBD)Ru(CO)₃), η4-butadienerutheniumtricarbonyl ((BD)Ru (CO₃)), η4-1,3-cyclohexadienerutheniumtricarbonyl ((CHD)Ru(CO)₃), bis(cyclopentadienylrutheniumdicarbonyl (C₁₄H₁₀O₄Ru₂)), tricarbonyldichlororuthenium(II) ([Ru(CO)₃Cl₂]₂), or the like. One or more of these gases may be used as the metal-containing gas.

For example, when the Ru-containing gas is used as the metal-containing gas, a Ru-containing layer is formed in the recess 400a on the wafer 200. The Ru-containing layer may be a Ru layer containing other elements, an adsorption layer of the Ru-containing gas, or both.

### (Residual Gas Removal: Step S12)

After a predetermined time, for example, 1 to 120 seconds is elapsed after starting the supply of the metal-containing gas, the valve 314 of the gas supply pipe 310 is closed to stop the supply of the metal-containing gas. That is, the time for supplying the metal-containing gas to the wafer 200 is, for example, 1 to 120 seconds. At this time, the APC valve 243 of the exhaust pipe 231 is kept open, and the inside of the process chamber 201 is vacuum-exhausted by the vacuum pump 246 to remove an unreacted metal-containing gas or a metal-containing gas contributed to the formation of the metal-containing layer, which remains in the process chamber 201, from the inside of the process chamber 201. That is, the inside of the process chamber 201 is purged. At this time, the valves 514, 524, 534 and 544 are kept open to maintain the supply of the inert gas into the process chamber 201. The inert gas acts as a purge gas, and may enhance the effect of removing the unreacted metal-containing gas or the metal-containing gas contributed to the formation of the metal-containing layer, which remains in the process chamber 201, from the inside of the process chamber 201.

### (Reducing Gas Supply: Step S13)

After removing the residual gas in the process chamber 201, the valve 324 is opened to flow a reducing gas into the gas supply pipe 320. A flow rate of the reducing gas is regulated by the MFC 322. The reducing gas is supplied into the process chamber 201 from the gas supply holes 420a of the nozzle 420, and is exhausted from the exhaust pipe 231. At this time, the reducing gas is supplied to the wafer 200. At this time, the valve 524 is simultaneously opened to flow an inert gas into the gas supply pipe 520. A flow rate of the inert gas flowing through the gas supply pipe 520 is regulated by the MFC 522. The inert gas is supplied into the process chamber 201 together with the reducing gas and exhausted from the exhaust pipe 231. At this time, in order to prevent the reducing gas from entering the nozzles 410, 430 and 440, the valves 514, 534 and 544 are opened to flow the inert gas into the gas supply pipes 510, 530 and 540. The inert gas is supplied into the process chamber 201 via the gas supply pipes 310, 330 and 340 and the nozzles 410, 430 and 440, and is exhausted from the exhaust pipe 231.

At this time, the APC valve 243 is controlled so that the pressure inside the process chamber 201 is regulated to a pressure within a range of, for example, 5 to 15,000 Pa. The supply flow rate of the reducing gas controlled by the MFC 322 is, for example, within a range of 1 to 100 slm, preferably 15 to 50 slm. The supply flow rate of the inert gas controlled by the MFCs 512 to 542 is, for example, within a range of 0.1 to 50 slm.

Herein, the pressure (total pressure) in the space where the wafers 200 exist, which is the pressure inside the process chamber 201 in this step, is set to be higher than a pressure (total pressure) in the space where the wafers 200 exist in step S23, which will be described later. That is, the pressure in the process chamber 201 in this step is set to be higher than a pressure in the process chamber 201 in step S23, which will be described later.

By increasing the pressure inside the process chamber 201 when the reducing gas is supplied, ligands in the film may be easily removed. If purging is performed at a high pressure during the residual gas removal in step S12 in order to remove the ligands, it will take time to return the pressure in the process chamber 201 to an original pressure. By increasing the pressure inside the process chamber 201 during the supply of the reducing gas in this step, the effect of removing (purge) the ligands may be obtained in a shorter time than when increasing the pressure inside the process chamber 201 during purging.

Furthermore, if the pressure inside the process chamber 201 is set to be high during the supply of the reducing gas in entire steps of the substrate processing process, time is consumed for pressure regulation from a low pressure to a high pressure between the supply of the metal-containing gas and the supply of the reducing gas. In the present disclosure, the pressure inside the process chamber 201 is increased when the reducing gas is supplied in the first metal-containing film formation process during the former half of the entire steps, and the pressure inside the process chamber 201 is reduced when the reducing gas is supplied in the second metal-containing film formation process during the latter half of the entire steps. This makes it possible to shorten the pressure regulation time between the supply of the metal-containing gas and the supply of the reducing gas. That is, it is possible to improve the productivity.

A partial pressure of the reducing gas in this step may be set to be higher than a partial pressure of the reducing gas in step S23, which will be described later. Furthermore, at least one selected from the group of the pressure inside the process chamber 201 and the partial pressure of the reducing gas in this step may be changed every predetermined cycle (first number of times). In other words, each time the number of cycles (first number of times) of the first metal-containing film formation process is performed, at least one selected from the group of the pressure inside the process chamber 201 and the partial pressure of the reducing gas during the supply of the reducing gas in this step may be changed. Specifically, in this step, at least one selected from the group of the pressure inside the process chamber 201 and the partial pressure of the reducing gas may be reduced every predetermined cycle (first number of times).

At this time, the gases flowing into the process chamber 201 are the reducing gas and the inert gas.

As the reducing gas, for example, a hydrogen (H)-containing gas such as a hydrogen (H₂) gas, a deuterium (D₂) gas, a gas containing activated hydrogen, or the like may be used. One or more of these gases may be used as the reducing gas.

When a H₂ gas is used as the reducing gas, the H₂ gas undergoes a substitution reaction with at least a portion of the metal-containing layer formed on the wafer 200 in step S11. For example, when a gas containing a metal element and a carbonyl group is used as the metal-containing gas, O or the like in the metal-containing layer reacts with H₂, is desorbed from the metal-containing layer, and is discharged from the inside of the process chamber 201 as reaction by-products such as water vapor (H₂O) and the like. Then, a metal-containing layer containing a metal element and a reduced O content is formed on the wafer 200.

### (Residual Gas Removal: Step S14)

After forming the metal-containing layer, the valve 324 is closed to stop the supply of the reducing gas. Then, an unreacted reducing gas, a reducing gas contributed to the formation of the metal-containing layer, and reaction by-products, which remain in the process chamber 201, are removed from the process chamber 201 by the same processing procedure as in step S12 described above. That is, the inside of the process chamber 201 is purged.

### (Performing a Predetermined Number of Times)

By performing a cycle of sequentially performing steps S11 to S14 described above at least once (first number of times (predetermined number of times) (n times)), as shown in FIG. 5C, a first metal-containing film 600a with a predetermined thickness is formed on the wafer (on the insulating film 400 on the surface and inside the recess 400a, i.e., on the metal-containing film 300 inside the recess 400a). Preferably, the above-described cycle is repeated multiple times. As a result, an amount of a surface oxide layer of the metal-containing film 300 may be reduced, and the first metal-containing film 600a in which the growth of an oxide layer at an interface is suppressed may be formed.

### [Second Metal-Containing Film Formation Process]

### (Metal-Containing Gas Supply: Step S21)

The valve 314 is opened to flow a metal-containing gas into the gas supply pipe 310. The metal-containing gas used in this step may be the same gas as the metal-containing gas used in the first metal-containing film formation process described above, or may be a different type of metal-containing gas. A flow rate of the metal-containing gas is regulated by the MFC 312. The metal-containing gas is supplied into the process chamber 201 from the gas supply holes 410a of the nozzle 410, and is exhausted from the exhaust pipe 231. At this time, a metal-containing gas is supplied to the wafer 200. At this time, the valve 514 is simultaneously opened to flow an inert gas into the gas supply pipe 510. A flow rate of the inert gas flowing through the gas supply pipe 510 is regulated by the MFC 512. The inert gas is supplied into the process chamber 201 together with the metal-containing gas, and is exhausted from the exhaust pipe 231. At this time, in order to prevent the metal-containing gas from entering the nozzles 420, 430 and 440, the valves 524, 523 and 544 are opened to flow the inert gas into the gas supply pipes 520, 530 and 540. The inert gas is supplied into the process chamber 201 via the gas supply pipes 320, 330 and 340 and the nozzles 420, 430 and 440, and is exhausted from the exhaust pipe 231.

At this time, the APC valve 243 is controlled so that the pressure inside the process chamber 201 is regulated to a pressure within a range of, for example, 1 to 3990 Pa. The supply flow rate of the metal-containing gas controlled by the MFC 312 is, for example, within a range of 0.05 to 1 slm. The supply flow rate of the inert gas controlled by the MFCs 512, 522, 532 and 542 is, for example, within a range of 0.1 to 50 slm.

At this time, the gases flowing into the process chamber 201 are the metal-containing gas and the inert gas. That is, the metal-containing gas is supplied to the first metal-containing film 600a as shown in FIG. 5C, and a metal-containing layer is formed on the wafer 200 (first metal-containing film 600a on the surface). The metal-containing layer may be a metal layer containing other elements, or may be an adsorption layer of the metal-containing gas.

### (Residual Gas Removal: Step S22)

After a predetermined time, for example, 1 to 120 seconds, is elapsed after starting the supply of the metal-containing gas, the valve 314 of the gas supply pipe 310 is closed to stop the supply of the metal-containing gas. Then, an unreacted metal-containing gas, a metal-containing gas contributed to the formation of the metal-containing layer, and reaction by-products, which remain in the process chamber 201, are removed from the process chamber 201 by the same processing procedure as in step S12 described above. That is, the inside of the process chamber 201 is purged.

(Simultaneous Supply of the Reducing Gas and the Oxygen-Containing Gas: Step S23) After the residual gas in the process chamber 201 is removed, the valves 324 and 334 are opened to flow a reducing gas into the gas supply pipe 320 and to flow a trace amount of oxygen-containing gas into the gas supply pipe 330. The reducing gas used in the second metal-containing film formation process may be the same gas as the reducing gas used in the first metal-containing film formation process, or may be a different type of reducing gas. A flow rate of the reducing gas is regulated by the MFC 322. The reducing gas is supplied into the process chamber 201 from the gas supply holes 420a of the nozzle 420, and is exhausted from the exhaust pipe 231. A flow rate of the oxygen-containing gas is regulated by the MFC 332. The oxygen-containing gas is supplied into the process chamber 201 from the gas supply holes 430a of the nozzle 430, and is exhausted from the exhaust pipe 231. At this time, the reducing gas and the oxygen-containing gas are supplied to the wafer 200 at the same time. That is, the supply of the oxygen-containing gas is started simultaneously with the start of the supply of the reducing gas. At this time, the valves 524 and 534 are simultaneously opened to flow an inert gas into the gas supply pipes 520 and 530, respectively. A flow rate of the inert gas flowing through the gas supply pipes 520 and 530 is regulated by the MFCs 522 and 532. The inert gas is supplied into the process chamber 201 together with the reducing gas and the oxygen-containing gas, and is exhausted from the exhaust pipe 231. At this time, in order to prevent the reducing gas and the oxygen-containing gas from entering the nozzles 410 and 440, the valves 514 and 544 are opened to flow the inert gas into the gas supply pipes 510 and 540. The inert gas is supplied into the process chamber 201 via the gas supply pipes 310 and 340 and the nozzles 410 and 440, and is exhausted from the exhaust pipe 231.

At this time, the APC valve 243 is controlled so that the pressure inside the process chamber 201 is regulated to a pressure within a range of, for example, 1 to 13,000 Pa. The supply flow rate of the reducing gas controlled by the MFC 322 is, for example, within a range of 1 to 100 slm, preferably 5 to 50 slm. The supply flow rate of the oxygen-containing gas controlled by the MFC 332 is, for example, within a range of 0.01 to 10 slm, preferably 0.1 to 5 slm. The supply flow rate of the inert gas controlled by the MFCs 512, 522, 532, and 542 is, for example, within a range of 0.1 to 50 slm.

At this time, the gases flowing into the process chamber 201 are the reducing gas, the oxygen-containing gas, and the inert gas. That is, the reducing gas and the oxygen-containing gas are supplied in parallel. The reducing gas and the oxygen-containing gas decompose the metal-containing gas and undergo a substitution reaction with at least a portion of the first metal-containing film 600a formed on the wafer 200.

By starting the supply of the oxygen-containing gas and the supply of the reducing gas at the same time, it is possible to enhance the effect of decomposing the metal-containing gas. That is, by performing this step, it is possible to remove organic ligands in the metal-containing gas. Further, by stopping the supply of the oxygen-containing gas and the supply of the reducing gas at the same time, it is possible to reduce oxygen atoms with the reducing gas and exhaust the oxygen atoms, thereby suppressing oxidation of the metal-containing film 300. Furthermore, by supplying the oxygen-containing gas and the reducing gas in parallel, it is possible to obtain the effects of both decomposition of the metal-containing gas and suppression of oxidation of the metal-containing film.

As the oxygen-containing gas, it may be possible to use gases containing oxygen (O) atoms, for example, an oxygen (O₂) gas, an ozone (O₃) gas, a plasma-excited O₂ (O₂*) gas, an O₂ gas + hydrogen (H₂) gas, a water vapor (H₂O gas), a hydrogen peroxide (H₂O₂) gas, a nitrous oxide (N₂O) gas, a nitrogen monoxide (NO) gas, a nitrogen dioxide (NO₂) gas, a carbon monoxide (CO) gas, a carbon dioxide (CO₂) gas, and the like. One or more of these gases may be used as the oxygen-containing gas.

For example, when a gas containing a metal element and a carbonyl group is used as the metal-containing gas, a H₂ gas is used as the reducing gas, and an O₂ gas is used as the oxygen-containing gas, the organic ligands in the first metal-containing film 600a react with H₂ and O₂, are desorbed from the first metal-containing film 600a, and are discharged from the process chamber 201 as a reaction by-product such as a water vapor (H₂O) or the like. Then, a metal-containing layer containing a metal element and substantially free of impurities is formed on the wafer 200.

### (Residual Gas Removal: Step S24)

Next, the valves 324 and 334 are closed to simultaneously stop the supply of the reducing gas and the supply of the oxygen-containing gas. That is, a timing of stopping the supply of the reducing gas and a timing of stopping the supply of the oxygen-containing gas are made at the same time. By stopping the supply of the oxygen-containing gas and the supply of the reducing gas at the same time as described above, it becomes possible to reduce oxygen atoms with the reducing gas and exhaust the oxygen atoms, thereby suppressing the oxidation of the first metal-containing film 600a. Then, an unreacted reducing gas or an unreacted oxygen-containing gas, a reducing gas or an oxygen-containing gas contributed to the formation of the metal-containing layer, and reaction by-products, which remain in the process chamber 201, are removed from the process chamber 201 by the same processing procedure as in step S12 described above. That is, the inside of the process chamber 201 is purged.

### (Performing a Predetermined Number of Times)

That is, by performing a cycle of sequentially performing steps S21 to S24 at least once or more (second number of times (m times)) after the first metal-containing film formation process described above, as shown in FIG. 5D, a second metal-containing film 600b with a predetermined thickness is formed on the first metal-containing film 600a of the wafer 200, and is modified into a metal-containing film 600. That is, as shown in FIG. 5E, a metal-containing film 600 may be formed on the metal-containing film 300. Preferably, the above-described cycle is repeated multiple times.

### (After-Purge and Atmospheric Pressure Restoration)

An inert gas is supplied into the process chamber 201 from each of the gas supply pipes 510 to 540, and is exhausted from the exhaust pipe 231. The inert gas acts as a purge gas, whereby the inside of the process chamber 201 is purged with the inert gas, and any gas and reaction by-products remaining in the process chamber 201 are removed from the inside of the process chamber 201 (after-purge). Thereafter, the atmosphere in the process chamber 201 is replaced with the inert gas (inert gas replacement), and the pressure in the process chamber 201 is restored to the atmospheric pressure (atmospheric pressure restoration).

### (Wafer Unloading)

Thereafter, the seal cap 219 is lowered by the boat elevator 115 to open a lower end of the outer tube 203. Then, the processed wafers 200 are unloaded from the lower end of the outer tube 203 to an outside of the outer tube 203 while being supported by the boat 217 (boat unloading). Thereafter, the processed wafers 200 are taken out from the boat 217 (wafer discharging).

That is, in the substrate processing process of the present disclosure, the first metal-containing film 600a in which the growth of the oxide layer at the interface on the metal-containing film 300 is suppressed is formed on the wafer 200 with the metal-containing film 300 formed on the surface thereof, by the first metal-containing film formation process. Subsequently, the second metal-containing film formation process is performed to form the second metal-containing film 600b in which impurities such as organic ligands in the first metal-containing film 600a are reduced. This makes it possible to form the metal-containing film 600 from which impurities are removed, on the metal-containing film 300 serving as the base film, while suppressing the oxidation of the metal-containing film 300.

### (3) Effects of the Present Embodiment

According to the present embodiments, one or more of the following effects may be obtained.
(a) Through the first metal-containing film formation process, it is possible to form the metal-containing film in which the growth of the oxide layer at the interface on the metal-containing film 300 is suppressed.
(b) Through the second metal-containing film formation process, it is possible to remove organic ligands in the metal-containing gas, and is possible to form the metal-containing film with reduced impurities in the film by promoting the decomposition of the metal-containing gas. Further, through the promotion of decomposition of the metal-containing gas, it is possible to increase the film formation rate and improve the productivity.
(c) By optimizing the number of cycles in the first metal-containing film formation process (the thickness of the first metal-containing film 600a) and the number of cycles in the second metal-containing film formation process (the thickness of the second metal-containing film 600b), it is possible to form a metal-containing film 600 in which both the suppression of formation of the oxide layer and the reduction of impurities in the film are improved.
(d) Furthermore, by performing the pretreatment process before the film formation process, it is possible to reduce the contact resistance between the metal-containing film 300 and the metal-containing film 600 embedded in the recess 400a.

### (4) Other Embodiments

The embodiments of the present disclosure are specifically described above. However, the present disclosure is not limited to the above-described embodiments, and various changes may be made without departing from the gist thereof. In addition, in the following modifications, the features different from the above-described embodiments will be described in detail.

### (Modification 1)

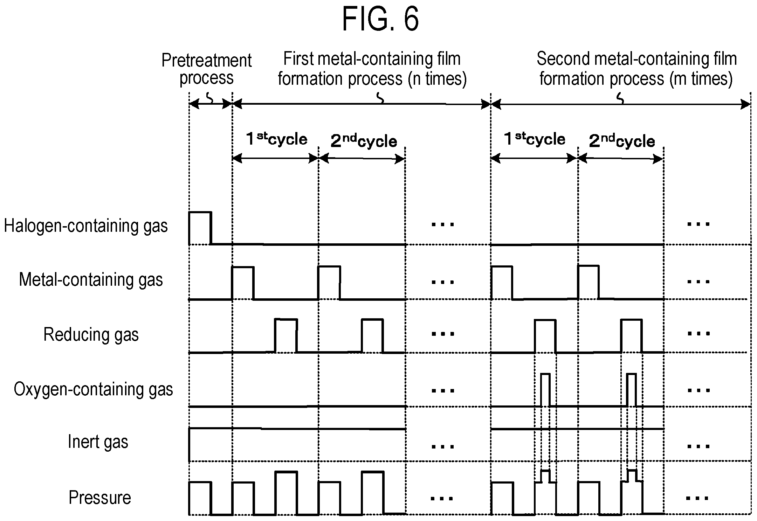

FIG. 6 is a diagram showing a modification of the substrate processing process shown in FIG. 4 described above.

In this modification, the substrate processing process and the second metal-containing film formation process described above are different. That is, in this modification, the timing of starting the supply of the reducing gas is different from the timing of starting the supply of the oxygen-containing gas in step S23 of the second metal-containing film formation process, and furthermore, the timing of stopping the supply of the reducing gas is different from the timing of stopping the supply of the oxygen-containing gas. Specifically, the supply of the oxygen-containing gas is started after starting the supply of the reducing gas, and the supply of the reducing gas is stopped after stopping the supply of the oxygen-containing gas. That is, there is a timing at which the oxygen-containing gas and the reducing gas are supplied in parallel.
Then, the pressure in the process chamber 201 at the timing at which the oxygen-containing gas and the reducing gas are supplied in parallel is set to be higher than the pressure in the process chamber 201 at a timing at which the reducing gas is supplied without supplying the oxygen-containing gas and the reducing gas in parallel.

By supplying the reducing gas before supplying the oxygen-containing gas in this way, it is possible to suppress the oxidation of the metal-containing film 300. Further, by stopping the supply of the reducing gas after stopping the supply of the oxygen-containing gas, it is possible to prevent oxygen atoms from remaining in the process chamber 201. Moreover, by providing the timing at which the oxygen-containing gas and the reducing gas are supplied in parallel, it is possible to obtain the effects of both the decomposition of the metal-containing gas and the suppression of the oxidation of the metal-containing film. In addition, even in this case, it is possible to obtain the same effects as in the substrate processing process shown in FIG. 4 described above.

### (Modification 2)

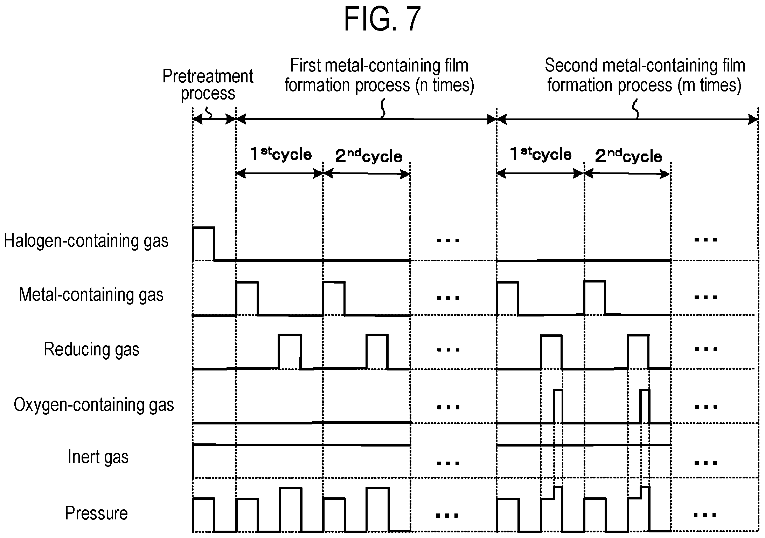

FIG. 7 is a diagram showing a modification of the substrate processing process shown in FIG. 4 described above.

In this modification, the substrate processing process and the second metal-containing film formation process described above are different. That is, in this modification, the timing of starting the supply of the reducing gas is different from the timing of starting the supply of the oxygen-containing gas in step S23 of the second metal-containing film formation process described above. Specifically, the supply of the oxygen-containing gas is started after starting the supply of the reducing gas, and the supply of the reducing gas is stopped simultaneously with stopping of the supply of the oxygen-containing gas. In other words, there is provided a timing at which the oxygen-containing gas and the reducing gas are supplied in parallel. Then, the pressure in the process chamber 201 at the timing at which the oxygen-containing gas and the reducing gas are supplied in parallel is set to be higher than the pressure in the process chamber 201 at a timing at which the reducing gas is supplied without supplying the oxygen-containing gas and the reducing gas in parallel.

By supplying the reducing gas before supplying the oxygen-containing gas in this way, it is possible to suppress the oxidation of the metal-containing film 300. Further, by stopping the supply of the oxygen-containing gas simultaneously with stopping of the supply of the reducing gas, it becomes possible to reduce the oxygen atoms with the reducing gas and exhaust the oxygen atoms, thus suppressing the oxidation of the metal-containing film 300. Further, by providing the timing at which the oxygen-containing gas and the reducing gas are supplied in parallel, it is possible to obtain the effects of both the decomposition of the metal-containing gas and the suppression of the oxidation of the metal-containing film. Furthermore, even in this case, it is possible to obtain the same effects as in the substrate processing process shown in FIG. 4 described above.

### (Modification 3)

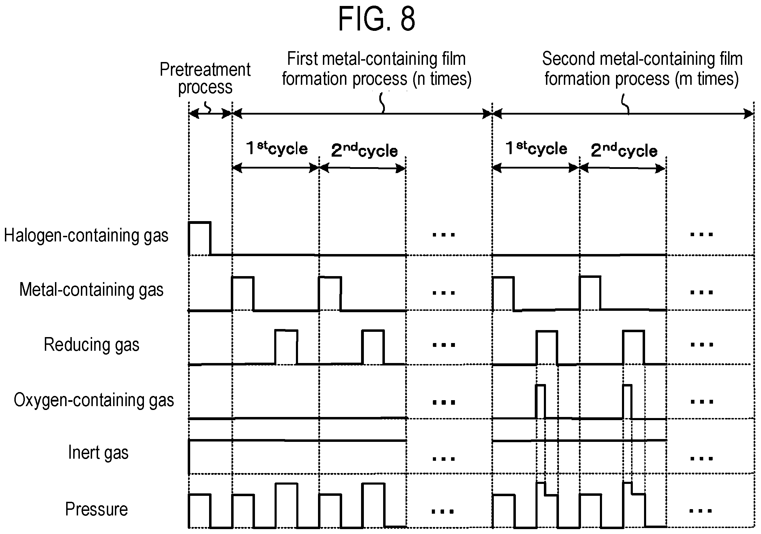

FIG. 8 is a diagram showing a modification of the substrate processing process shown in FIG. 4 described above.

In this modification, the substrate processing process and the second metal-containing film formation process described above are different. That is, in this modification, the supply of the oxygen-containing gas is started simultaneously with starting of the supply of the reducing gas in step S23 of the second metal-containing film formation process described above, and the timing of stopping the supply of the reducing gas is different from the timing of stopping the supply of the oxygen-containing gas. That is, the supply of the oxygen-containing gas is started simultaneously with starting of the supply of the reducing gas, and the supply of the reducing gas is stopped after stopping the supply of the oxygen-containing gas. In other words, there is a timing at which the oxygen-containing gas and the reducing gas are supplied in parallel. Then, the pressure in the process chamber 201 at the timing at which the oxygen-containing gas and the reducing gas are supplied in parallel is higher than the pressure in the process chamber 201 at a timing at which the reducing gas is supplied without supplying the oxygen-containing gas and the reducing gas in parallel.

By starting the supply of the oxygen-containing gas simultaneously with starting of the supply of the reducing gas in this way, it is possible to enhance the effect of decomposing the metal-containing gas. Further, by stopping the supply of the reducing gas after stopping the supply of the oxygen-containing gas, it is possible to prevent oxygen atoms from remaining in the process chamber 201. Moreover, by providing the timing at which the oxygen-containing gas and the reducing gas are supplied in parallel, it is possible to obtain the effects of both the decomposition of the metal-containing gas and the suppression of the oxidation of the metal-containing film. In addition, even in this case, it is possible to obtain the same effects as in the substrate processing process shown in FIG. 4 described above.

### (Modification 4)

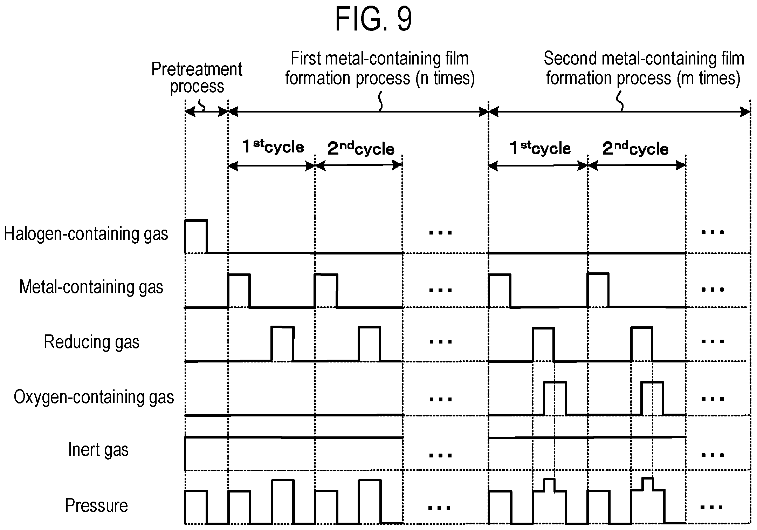

FIG. 9 is a diagram showing a modification of the substrate processing process shown in FIG. 4 described above.

In this modification, the substrate processing process and the second metal-containing film formation process described above are different. That is, in this modification, the timing of starting the supply of the reducing gas is different from the timing of starting the supply of the oxygen-containing gas in step S23 of the second metal-containing film formation process described above, and furthermore, the timing of stopping the supply of the reducing gas is different from the timing of stopping the supply of the oxygen-containing gas. Specifically, the supply of the oxygen-containing gas is started after starting the supply of the reducing gas, and the supply of the oxygen-containing gas is stopped after stopping the supply of the reducing gas. In other words, there is provide a timing at which the oxygen-containing gas and the reducing gas are supplied in parallel. Then, the pressure in the process chamber 201 at the timing at which the oxygen-containing gas and the reducing gas are supplied in parallel is set to be higher than the pressure in the process chamber 201 at a timing at which the reducing gas or the oxygen-containing gas is supplied without supplying the oxygen-containing gas and the reducing gas in parallel.

By supplying the reducing gas before supplying the oxygen-containing gas in this way, it is possible to suppress the oxidation of the metal-containing film 300. Further, by stopping the supply of the oxygen-containing gas after stopping the supply of the reducing gas, it is possible to form a metal-containing film having an oxide film formed on the surface thereof. Moreover, by providing the timing at which the oxygen-containing gas and the reducing gas are supplied in parallel, it is possible to obtain the effects of both the decomposition of the metal-containing gas and the suppression of the oxidation of the metal-containing film. In addition, even in this case, it is possible to obtain the same effects as in the substrate processing process shown in FIG. 4 described above.

### (Modification 5)

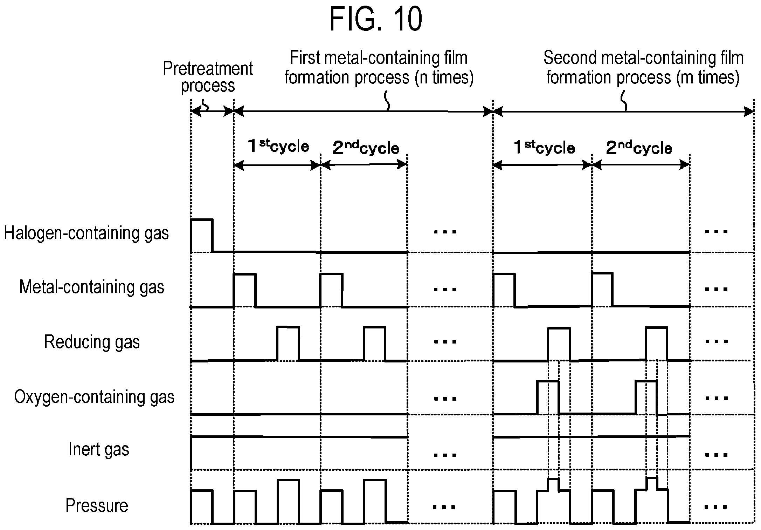

FIG. 10 is a diagram showing a modification of the substrate processing process shown in FIG. 4 described above.

In this modification, the substrate processing process and the second metal-containing film formation process are different. That is, in this modification, the timing of starting the supply of the reducing gas is different from the timing of starting the supply of the oxygen-containing gas in step S23 of the second metal-containing film formation process, and furthermore, the timing of stopping the supply of the reducing gas is different from the timing of stopping the supply of the oxygen-containing gas. Specifically, the supply of the reducing gas is started after starting the supply of the oxygen-containing gas, and the supply of the reducing gas is stopped after stopping the supply of the oxygen-containing gas. In other words, there is a timing at which the oxygen-containing gas and the reducing gas are supplied in parallel. Then, the pressure in the process chamber 201 at the timing at which the oxygen-containing gas and the reducing gas are supplied in parallel is set to be higher than the pressure in the process chamber 201 at a timing at which the reducing gas or the oxygen-containing gas is supplied without supplying the oxygen-containing gas and the reducing gas in parallel.

By supplying the oxygen-containing gas before supplying the reducing gas in this way, it is possible to enhance the effect of decomposing the metal-containing gas. Further, by stopping the supply of the reducing gas after stopping the supply of the oxygen-containing gas, it is possible to prevent oxygen atoms from remaining in the process chamber 201. Moreover, by providing the timing at which the oxygen-containing gas and the reducing gas are supplied in parallel, it is possible to obtain the effects of both the decomposition of the metal-containing gas and the suppression of the oxidation of the metal-containing film. In addition, even in this case, it is possible to obtain the same effects as in the substrate processing process shown in FIG. 4 described above.

### (Modification 6)

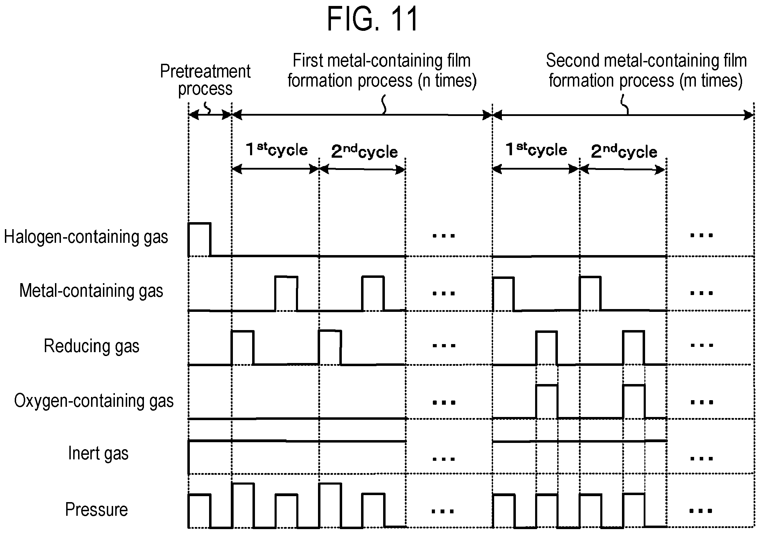

FIG. 11 is a diagram showing a modification of the substrate processing process shown in FIG. 4 described above.

In this modification, the order of gas supply in the substrate processing process and the first metal-containing film formation process described above is different. That is, in the first metal-containing film formation process, the process starts with the supply of the reducing gas in step S13 described above. That is, before the supply of the metal-containing gas of step S11, the supply of the reducing gas of step S13 is performed.

After the pretreatment process, there is a possibility that the halogen-containing gas is adsorbed onto the wafer 200. As in this modification, by starting the first metal-containing film formation process, coming after the pretreatment process, with the supply of the reducing gas, it is possible to remove the halogen element adsorbed onto the wafer 200. For example, when a gas containing Cl is used as the halogen-containing gas and a H₂ gas is used as the reducing gas, the H₂ gas reacts with Cl adsorbed onto the wafer 200, thus desorbing Cl from the wafer 200 and discharging Cl from the process chamber 201 as a reaction by-product such as hydrogen chloride (HCl), chlorine (Cl₂) or the like.

Furthermore, when a H-containing gas is used as the reducing gas, by starting with the supply of the reducing gas after the pretreatment process, the surface of the metal-containing film 300 may become H-terminated, thus suppressing the oxidation of the metal-containing film 300. This is effective even when no pretreatment process is performed. Specifically, when a H₂ gas is used as the reducing gas, the H₂ gas reacts with O adsorbed onto the wafer 200, thus desorbing O from the wafer 200 and discharging O from the process chamber 201 as a reaction by-product such as a water vapor (H₂O) or the like. This makes it possible to remove O adsorbed onto the wafer 200 and thus suppress the oxidation of the metal-containing film 300, which serves as the base film. Furthermore, even in this case, it is possible to obtain the same effects as in the substrate processing process shown in FIG. 4 described above.

### (Modification 7)

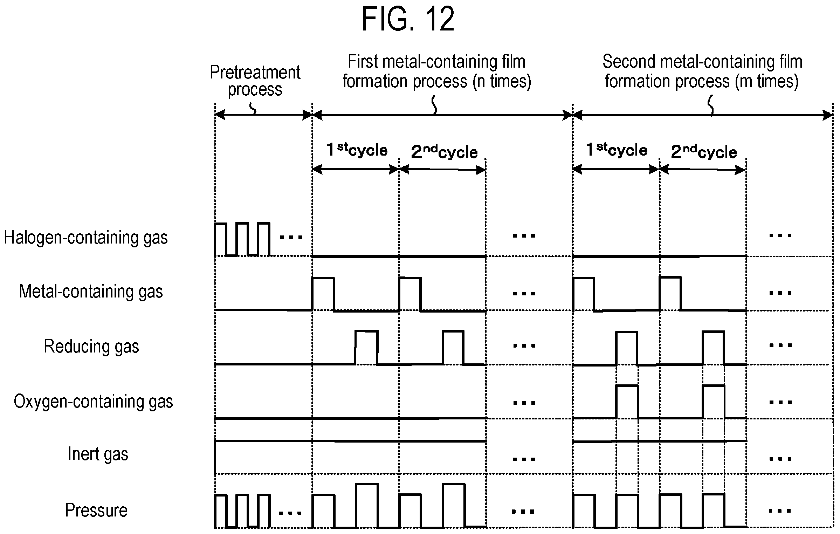

FIG. 12 is a diagram showing a modification of the substrate processing process shown in FIG. 4 described above.

In this modification, the substrate processing process and the pretreatment process shown in FIG. 4 described above are different. In the pretreatment process of this modification, the supply of the halogen-containing gas in step S 1 and the removal (exhaust) of the residual gas in step S2 are repeated a predetermined number of times. That is, cyclic processing is performed. As a result, it is possible to obtain the same effects as in the substrate processing process shown in FIG. 4 described above, and it is also possible to suppress the reaction by-products from remaining and to promote the discharge of the reaction by-products.

### (Modification 8)

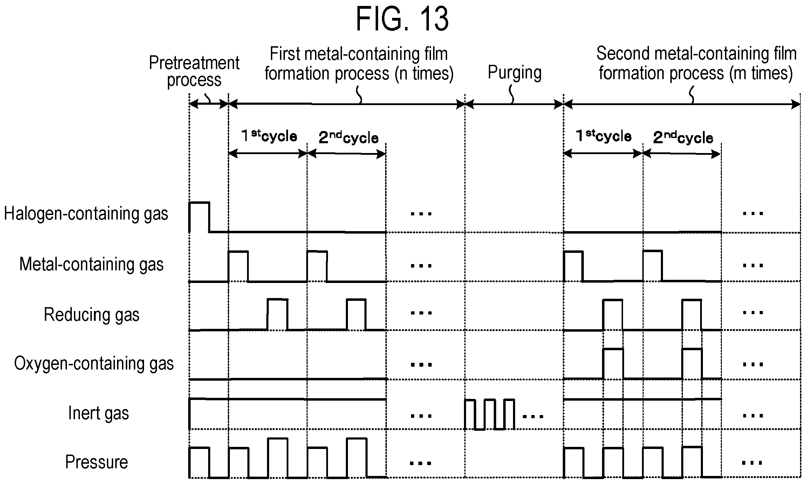

FIG. 13 is a diagram showing a modification of the substrate processing process shown in FIG. 4 described above.

In this modification, a step of supplying an inert gas as a purge gas into the process chamber 201 and a step of exhausting the atmosphere inside the process chamber 201 are repeated a predetermined number of times between the first metal-containing film formation process and the second metal-containing film formation process shown in FIG. 4 described above. As a result, it is possible to obtain the same effects as in the substrate processing process shown in FIG. 4 described above, and it is also possible to suppress the reaction by-products from remaining and to promote the discharge of the reaction by-products.

In the above-described embodiments, examples in which a predetermined film is formed on the wafer 200 are described. However, the present disclosure is not particularly limited to a type of film.

Further, in the above-described embodiments, examples are described where a film is formed using the substrate processing apparatus which is a batch-type vertical apparatus that processes multiple substrates at a time. However, the present disclosure is not limited thereto, and the present disclosure may also be suitably applied when forming a film using a single-substrate type substrate processing apparatus that processes one or several substrates at a time.

Preferably, recipes (programs that describe processing procedures, processing conditions, etc.) used for substrate processing are individually prepared according to processing contents (film type, composition ratio, film quality, film thickness, processing procedure, processing condition, etc.), and are stored in the memory 121c via a telecommunication line or the external memory 123. Then, when starting substrate processing, the CPU 121a relevantly selects an appropriate recipe from the plurality of recipes stored in the memory 121c according to the processing contents. This makes it possible to form films of various film types, composition ratios, film qualities, and film thicknesses with good reproducibility using one substrate processing apparatus. In addition, the burden on an operator (the burden of inputting processing procedures, processing conditions, etc.) may be reduced, and thus the substrate processing may be commenced promptly while avoiding operational errors.

The above-mentioned process recipes are not limited to being newly created, but may be prepared by, for example, changing existing recipes that are already installed in the substrate processing apparatus. When changing the recipes, the changed recipes may be installed in the substrate processing apparatus via a telecommunication line or a recording medium on which the recipes are recorded. Alternatively, the input/output device 122 installed in the existing substrate processing apparatus may be operated to directly change existing recipes already installed in the substrate processing apparatus.

### EXPLANATION OF REFERENCE NUMERALS

10: substrate processing apparatus
121: controller
200: wafer (substrate)
201: process chamber

## Claims

1. A method of manufacturing a semiconductor device, comprising:
(a) supplying a metal-containing gas containing a metal element to a substrate on which a metal-containing film is formed;
(b) supplying a reducing gas to the substrate;
(c) supplying an oxygen-containing gas containing an oxygen atom and the reducing gas to the substrate;
(d) repeating a cycle including (a) and (b) a first number of times; and
(e) after (d), repeating a cycle including (a) and (c) a second number of times.

2. The method of Claim 1, wherein in (c), a timing of starting the supply of the reducing gas is different from a timing of starting the supply of the oxygen-containing gas.

3. The method of Claim 1 or 2, wherein in (c), the supply of the oxygen-containing gas is started after starting the supply of the reducing gas.

4. The method of Claim 1, wherein in (c), the supply of the oxygen-containing gas is started simultaneously with starting of the supply of the reducing gas.

5. The method of Claim 1 or 2, wherein in (c), the supply of the reducing gas is started after starting the supply of the oxygen-containing gas.

6. The method of any one of Claims 1 to 5, wherein in (c), a timing of stopping the supply of the reducing gas is different from a timing of stopping the supply of the oxygen-containing gas.

7. The method of any one of Claims 1 to 6, wherein in (c), the supply of the reducing gas is stopped after stopping the supply of the oxygen-containing gas.

8. The method of any one of Claims 1 to 5, wherein in (c), the supply of the reducing gas is stopped simultaneously with stopping of the supply of the oxygen-containing gas.

9. The method of any one of Claims 1 to 6, wherein in (c), the supply of the oxygen-containing gas is stopped after stopping the supply of the reducing gas.

10. The method of any one of Claims 1 to 9, wherein in (c), a timing at which the oxygen-containing gas and the reducing gas are supplied in parallel is provided.

11. The method of any one of Claims 1 to 10, wherein a pressure in a space where the substrate exists in (b) performed in the cycle of (d) is set to be higher than a pressure in a space where the substrate exists in (c) performed in the cycle of (e).

12. The method of any one of Claims 1 to 11, wherein a partial pressure of the reducing gas in (b) performed in the cycle of (d) is set to be higher than a partial pressure of the reducing gas in (c) performed in the cycle of (e).

13. The method of any one of Claims 1 to 12, wherein at least one selected from the group of a pressure in a space where the substrate exists and a partial pressure of the reducing gas, in (b) performed in the cycle of (d), is changed for each of the first number of times.

14. The method of any one of Claims 1 to 13, wherein at least one selected from the group of a pressure in a space where the substrate exists and a partial pressure of the reducing gas, in (b) performed in the cycle of (d), is reduced for each of the first number of times.

15. The method of any one of Claims 1 to 14, wherein in (d), the cycle is started from (b).

16. The method of any one of Claims 1 to 15, wherein an oxide film is formed on the metal-containing film, and further comprising:
(f) before (d), supplying a halogen-containing gas containing a halogen element to the substrate to remove at least a portion of the oxide film.

17. The method of Claim 16, wherein in (f), the supply of the halogen-containing gas and an exhaust of a space where the substrate exists are repeated.

18. The method of Claim 16 or 17, wherein the halogen element contained in the halogen-containing gas is chlorine.

19. The method of any one of Claims 16 to 18, wherein the halogen-containing gas is a gas further containing oxygen.

20. The method of any one of Claims 16 to 19, wherein the halogen-containing gas is a gas containing at least one selected from the group of POCl₃, SOCl₂, and COCl₂.

21. The method of any one of Claims 1 to 20, wherein the metal element contained in the metal-containing film is a transition metal.

22. The method of Claim 21, wherein the transition metal is at least one selected from the group of W, Mo, Cu, and Co.

23. The method of any one of Claims 1 to 22, wherein the metal-containing gas is a gas containing a carbonyl group.

24. The method of any one of Claims 1 to 23, wherein the metal element contained in the metal-containing gas is a transition metal.

25. The method of Claim 24, wherein the metal element contained in the metal-containing gas is a platinum group element.

26. The method of Claim 25, wherein the metal element contained in the metal-containing gas is a Group 8 element.

27. The method of Claim 26, wherein the metal element contained in the metal-containing gas is Ru.

28. The method of any one of Claims 1 to 27, further comprising:
between (d) and (e), repeating a supply of a purge gas to a space where the substrate exists and an exhaust of the space where the substrate exists.

29. A method of processing a substrate, comprising:
(a) supplying a metal-containing gas containing a metal element to the substrate on which a metal-containing film is formed;
(b) supplying a reducing gas to the substrate;
(c) supplying an oxygen-containing gas containing an oxygen atom and the reducing gas to the substrate;
(d) repeating a cycle including (a) and (b) a first number of times; and
(e) after (d), repeating a cycle including (a) and (c) a second number of times.

30. A substrate processing apparatus, comprising:
a process container;
a metal-containing gas supply system configured to supply a metal-containing gas containing a metal element into the process container;
a reducing gas supply system configured to supply a reducing gas into the process container;
an oxygen-containing gas supply system configured to supply an oxygen-containing gas containing an oxygen atom into the process container; and
a controller configured to be capable of controlling the metal-containing gas supply system, the reducing gas supply system, and the oxygen-containing gas supply system so as to perform:
(a) supplying the metal-containing gas to a substrate on which a metal-containing film is formed in the process container;
(b) supplying the reducing gas to the substrate;
(c) supplying the oxygen-containing gas and the reducing gas to the substrate;
(d) repeating a cycle including (a) and (b) a first number of times; and
(e) after (d), repeating a cycle including (a) and (c) a second number of times.

31. A computer-readable recording medium storing a program that causes, by a computer, a substrate processing apparatus to perform:
(a) supplying a metal-containing gas containing a metal element to a substrate on which a metal-containing film is formed;
(b) supplying a reducing gas to the substrate;
(c) supplying an oxygen-containing gas containing an oxygen atom and the reducing gas to the substrate;
(d) repeating a cycle including (a) and (b) a first number of times; and
(e) after (d), repeating a cycle including (a) and (c) a second number of times.
